# FASCICULE DE BREVET EUROPEEN

(11) **EP 3 391 523 B1**
(45) Date de publication et mention de la délivrance du brevet: **27.11.2019**
(21) Numéro de dépôt: 16802119.4
(22) Date de dépôt: 30.11.2016
(51) Int. Cl.: H02M 1/34, H02M 3/158

(54) **CONVERTISSEUR A DECOUPAGE**
SCHALTREGLER
SWITCHING CONTROLLER

(30) Priorité: 15.12.2015 FR 1562364
(43) Date de publication de la demande: 24.10.2018
(73) Titulaire: Safran Electronics & Defense, 92100 Boulogne-Billancourt (FR)
(72) Inventeur: GRIMAUD, Louis, 92100 Boulogne Billancourt (FR)
(74) Mandataire: Decorchemont, Audrey Véronique Christèle
(86) Numéro de dépôt international: PCT/EP2016/079348
(87) Numéro de publication internationale: WO 2017/102337

(56) Documents cités:
- EP-A1- 1 959 549

## Description

L'invention se rapporte à un convertisseur à découpage unipolaire ou bipolaire, fonctionnant dans les quadrants (Is>0; Vs>0) et (Is<0; Vs<0), ainsi qu'à courant ou tension de sortie nuls, possédant des enroulements magnétiquement couplés, pouvant être configuré avec le mode de régulation adapté en source de courant ou source de tension. Elle s'applique dans tous les types d'équipement terrestre, naval ou aérien utilisant ce type de convertisseur à découpage notamment les commandes d'actuateur électromécanique des automates de régulation pour turbomoteur.

L'invention concerne également une commande d'actuateur électromécanique comportant un tel convertisseur, un automate de régulation comportant un tel convertisseur, un équipement terrestre, naval ou aéronautique comportant un tel convertisseur et un turbomoteur comportant un tel convertisseur.

### ARRIERE PLAN TECHNOLOGIQUE DE L'INVENTION

La commande d'actionneurs électriques présentant une charge de type RL (résistance et inductance en série) peut être réalisée soit par application d'une tension régulée aux bornes de la bobine de commande de l'actionneur, soit par une source de courant, cette dernière solution étant souvent préférée en environnement sévère car elle permet essentiellement de limiter la puissance utilisée pour commander l'accessoire et de simplifier le correcteur associé.

Les sources de courant à découpage peuvent classiquement être regroupées parmi les sources de courant utilisant l'inductance de la charge comme élément de stockage de l'énergie lors de l'opération de découpage, avec pour conséquence l'application aux bornes de la charge, à la fréquence de découpage, d'une tension alternativement positive et négative, les transitions entre ces deux états pouvant dans l'idéal être considérées comme instantanées, et les sources de courant fournissant un courant continu et, par voie de conséquence, une tension continue aux bornes de la charge, dont l'élément de stockage d'énergie pour le découpage est situé sur la carte de commande elle-même.

Les sources de courant à découpage utilisant l'inductance de la charge comme élément de stockage d'énergie ont l'avantage de présenter une commande qui est à première vue simple. Elles ne comportent peu ou éventuellement pas d'éléments inductifs, ce qui conduit à un gain certain dans les dimensions du circuit. Par contre, elles présentent un certain nombre d'inconvénients. Elles présentent une grande dépendance vis-à-vis de la valeur de l'inductance de la charge : la capacité à contrôler le courant instantané dans les interrupteurs de la source de courant dépend directement de la valeur de l'inductance de charge. La tenue aux courts-circuits entre les bornes de sortie du convertisseur ou entre une quelconque borne de sortie et la masse est très difficile. En effet, en cas de court-circuit de la charge, il n'est pas possible, sauf à ajouter des composants, de limiter le courant instantané. En conséquence, on est contraint en pratique d'ajouter une inductance en sortie du convertisseur afin de limiter le courant de court-circuit, d'ajouter un dispositif de protection et de coupure très rapide pour limiter la valeur maximale du courant de court-circuit, d'ajouter un circuit de démagnétisation de l'inductance de sortie pour gérer la coupure après la détection du court-circuit en sortie, de surdimensionner les interfaces (condensateur de filtrage d'entrée) pour qu'elles puissent supporter le courant de court-circuit. Concernant l'aspect compatibilité électromagnétique (émissions conduites essentiellement), ces convertisseurs sont difficiles à rendre compatibles avec les normes d'émission aéronautiques, si on veut une fréquence de découpage élevée pour limiter l'encombrement des composants passifs des convertisseurs, surtout si la charge est commandée au bout de plusieurs mètres de câble. Il en résulte une fréquence de découpage réduite typiquement en dessous de 10 kHz et une obligation de dimensionner un filtre de sortie (mode commun et mode différentiel) qui jouera un rôle de premier plan sur la stabilité de l'ensemble et présentera un encombrement non négligeable. Ce type de source de courant à découpage est restreint à des applications de forte puissance, pour lesquelles une fréquence de découpage faible n'est pas forcément un handicap. Pour les convertisseurs fournissant une tension continue aux bornes de la charge, le découpage ne s'effectue plus dans la charge mais le courant (ou la tension) est régulé en sortie d'un convertisseur à découpage comprenant une inductance stockant au minimum toute l'énergie transférée à la charge et un condensateur est ajouté pour lisser la tension de sortie. En conséquence, la tension de sortie est quasiment continue aux bornes de la charge. Il y a donc moins de difficultés pour tenir les normes aéronautiques de bruit émis en conduction. En cas de court-circuit de la charge, le courant dans le convertisseur reste naturellement limité. On peut envisager des fréquences de découpage dépassant les 100 kHz, limitées en fait par le rendement du convertisseur et la performance des circuits de commande de grille des éléments interrupteurs. EP1959549 est un exemple de convertisseur de l'art antérieur.

La figure la est un schéma électrique d'un convertisseur de l'art antérieur fournissant une tension continue aux bornes d'une charge. Le circuit est alimenté par une tension positive Vp (par exemple +25V) et une tension négative Vm (par exemple -25V) par rapport à la masse. Il comprend deux éléments T1 et T2 comprenant chacun deux enroulements magnétiquement couplés autour d'un noyau magnétique. Les enroulements d'un même élément T1 ou T2 sont bobinés en opposition comme indiqué par un point sur la figure la. L'enroulement E1 de l'élément T1 possède une première extrémité reliée à la tension Vp par l'intermédiaire d'une diode D5 montée en inverse par rapport à la tension Vp, sa deuxième extrémité étant à la masse. L'enroulement E2 de l'élément T1 possède une première extrémité reliée à une première borne d'un interrupteur Q3 dont la deuxième borne est reliée à la tension Vp. La deuxième extrémité de l'enroulement E2 est reliée à la borne de sortie S1P du circuit. L'enroulement E3 de l'élément T2 possède une première extrémité reliée à la tension Vm par l'intermédiaire d'une diode D6 montée en inverse par rapport à la tension Vm, sa deuxième extrémité étant à la masse. L'enroulement E4 de l'élément T2 possède une première extrémité reliée à une première borne d'un interrupteur Q4 dont la deuxième borne est reliée à la tension Vm. La deuxième extrémité de l'enroulement E4 est reliée à la borne de sortie S1P du circuit. Un condensateur de lissage Cl est branché entre la sortie S1P et la masse.

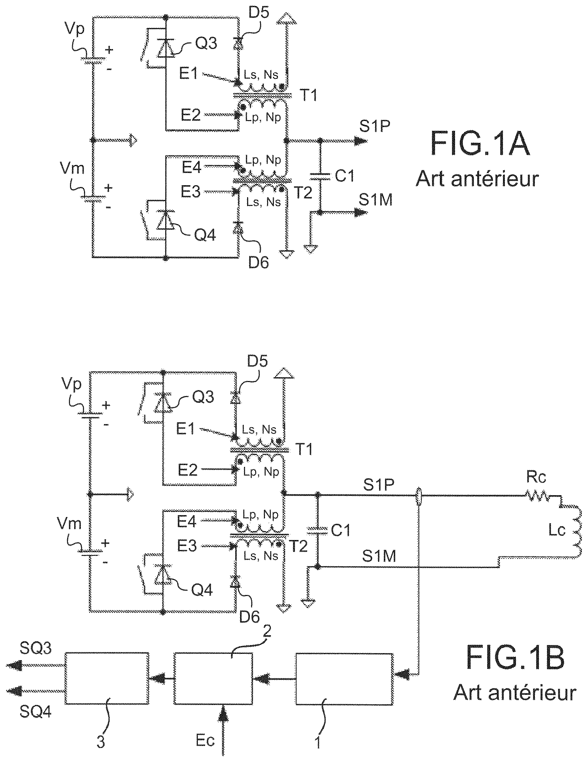

Le convertisseur est transformé en source de courant par l'ajout d'un moyen de mesure du courant de sortie, d'une régulation et d'un modulateur adaptés. C'est ce que montre la figure 1b où la charge branchée en sortie du convertisseur est représentée sous la forme d'une résistance Rc et d'une inductance Lc branchées en série. Le courant de sortie est mesuré par un moyen de mesure 1 qui délivre un signal représentatif à une première entrée d'un moyen de régulation (ou correcteur) 2. Une deuxième entrée Ec du moyen de régulation 2 reçoit un signal de consigne. Le signal de sortie du moyen de régulation 2 est adressé à l'entrée d'un modulateur 3 qui délivre un signal de commande SQ3 à l'interrupteur Q3 et un signal de commande SQ4 à l'interrupteur Q4.

Le convertisseur illustré par les figures la et 1b comprend donc quatre enroulements et deux noyaux magnétiques, ce qui conduit à un coût relativement élevé et un encombrement du circuit relativement grand.

Afin de diminuer le coût et l'encombrement d'un tel convertisseur, la demande de brevet EP 1 959 549 de la présente demanderesse propose un circuit à deux enroulements couplés sur un seul noyau magnétique.

Toutefois, dans ce circuit, les deux enroulements présentent un nombre de spires différent afin d'éviter d'éventuels problèmes de « conduction croisée » (plus connu en anglais sous le terme de « cross-conduction ») . Or ceci oblige à avoir recours à des éléments spécifiques pour créer les enroulements de sorte que le convertisseur demeure d'un coût relativement élevé.

### OBJET DE L'INVENTION

Un but de l'invention est de proposer un convertisseur à découpage qui soit d'un coût davantage réduit. L'invention concerne également une commande d'actuateur électromécanique comportant un tel convertisseur, un automate de régulation comportant un tel convertisseur, un équipement terrestre, naval ou aéronautique comportant un tel convertisseur et un turbomoteur comportant un tel convertisseur.

### BREVE DESCRIPTION DE L'INVENTION

En vue de la réalisation de ce but, on propose un convertisseur à découpage alimenté par une tension positive et une tension négative par rapport à la masse, et délivrant une tension de sortie entre une première borne de sortie et une deuxième borne de sortie, cette dernière étant reliée à la masse directement ou à travers une résistance, le convertisseur comprenant deux enroulements bobinés en opposition autour d'un noyau magnétique,
- la première extrémité du premier enroulement étant reliée à un point milieu d'une première branche qui relie la tension positive à la tension négative, la partie de la première branche reliant son point milieu à la tension positive comprenant, disposés en série, un premier moyen formant interrupteur et une première diode montée en direct par rapport à la tension positive et formant ensemble un interrupteur unidirectionnel à pouvoir de blocage direct et inverse, la partie de la première branche reliant son point milieu à la tension négative comprenant, disposés en série, un deuxième moyen formant interrupteur et une deuxième diode montée en direct par rapport à la tension négative et formant ensemble un interrupteur unidirectionnel à pouvoir de blocage direct et inverse,
- la deuxième extrémité du premier enroulement étant reliée à la borne de sortie,
- la première extrémité du deuxième enroulement étant reliée à un point milieu d'une deuxième branche qui relie la tension positive à la tension négative et qui comprend une troisième diode et une quatrième diode montées en inverse, le point milieu de la deuxième branche étant situé entre la troisième diode et la quatrième diode.

Selon l'invention, le convertisseur comporte un troisième moyen formant interrupteur et un quatrième moyen formant interrupteur formant ensemble un interrupteur bidirectionnel à pouvoir de blocage direct et inverse, le troisième moyen et le quatrième moyen étant disposés en série entre la deuxième extrémité du deuxième enroulement et la masse.

Grâce à l'ensemble formé par le troisième moyen et le quatrième moyen, il s'avère possible de contrôler le passage du courant dans le deuxième enroulement relié à la masse via ledit ensemble.

Ainsi, il n'est donc plus nécessaire d'avoir une dissymétrie des deux enroulements. Comme, le premier enroulement et le deuxième enroulement peuvent présenter un nombre de spires identique, il s'avère possible d'avoir recours à des éléments standards du commerce pour former ces enroulements ce qui abaisse le prix du convertisseur.

En outre, ces éléments demeurent d'un encombrement relativement faible ce qui permet de ne pas augmenter outre mesure les dimensions du convertisseur.

Selon un mode de réalisation particulier, un condensateur de lissage est branché entre la première borne de sortie du convertisseur et la masse.

Selon un mode de réalisation particulier, dans la première branche reliant la tension positive à la tension négative, la disposition en série consiste à disposer les premier et deuxième moyens formant interrupteur du côté des tensions positive ou négative respectives et à disposer les première et deuxième diodes du côté du point milieu de la première branche.

Selon un mode de réalisation particulier, les premier, deuxième, troisième et quatrième moyens formant interrupteur sont choisis parmi les transistors MOS, les transistors bipolaires et les transistors IGBT ou tout autre interrupteur ayant une capacité de conduction bidirectionnelle et une capacité de blocage direct.

Selon un mode de réalisation particulier, le troisième moyen et le quatrième moyen formant interrupteur sont choisis parmi les transistors MOS.

Selon un mode de réalisation particulier, le troisième moyens et le quatrième moyen formant interrupteur sont respectivement l'un un transistor MOS à canal N et l'autre un transistor MOS à canal P.

Selon un mode de réalisation particulier, le troisième moyen formant interrupteur est de même type que le premier moyen formant interrupteur.

Selon un mode de réalisation particulier, le deuxième moyen formant interrupteur est de même type que le quatrième moyen formant interrupteur.

Selon un mode de réalisation particulier, le convertisseur comporte un moyen de mesure de la tension de sortie du convertisseur, ce moyen de mesure délivrant un signal de sortie représentatif de la tension de sortie à une première entrée d'un moyen de régulation dont une deuxième entrée reçoit un signal de consigne, le moyen de régulation délivrant un signal fourni à l'entrée d'un modulateur dont une première sortie envoie un même signal de commande au premier moyen formant interrupteur et au troisième moyen formant interrupteur et dont une deuxième sortie envoie un même signal de commande au deuxième moyen formant interrupteur et au quatrième moyen formant interrupteur, le convertisseur étant ainsi configuré en source de tension.

Selon un mode de réalisation particulier, le convertisseur comprend en outre un moyen de mesure du courant de sortie du convertisseur, ce moyen de mesure délivrant un signal de sortie représentatif du courant de sortie du convertisseur à une première entrée d'un moyen de régulation dont une deuxième entrée reçoit un signal de consigne, le moyen de régulation délivrant un signal fourni à l'entrée d'un modulateur dont une première sortie envoie un même signal de commande au premier moyen formant interrupteur et au troisième moyen formant interrupteur et dont une deuxième sortie envoie un même signal de commande au deuxième moyen formant interrupteur et au quatrième moyen formant interrupteur, le convertisseur étant ainsi configuré en source de courant.

L'invention concerne également une commande d'actuateur électromécanique comportant un convertisseur à découpage précité.

L'invention concerne également un automate de régulation comportant un convertisseur à découpage précité.

L'invention concerne également un équipement terrestre, naval ou aéronautique comportant un convertisseur à découpage précité.

L'invention concerne également un turbomoteur comportant un convertisseur à découpage précité.

### BREVE DESCRIPTION DES FIGURES

Les figures 1a et 1b ont déjà été introduites et représentent respectivement un schéma électrique d'un convertisseur à découpage de l'art antérieur fournissant une tension continue aux bornes d'une charge, et un schéma électrique dudit convertisseur utilisé en tant que source de courant à découpage par ajout d'un moyen de mesure du courant de sortie, ainsi que des correcteur et modulateur adéquats.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 2 est un schéma électrique d'un convertisseur à découpage fournissant une tension continue aux bornes d'une charge, selon l'invention,
- les figures 3A à 3N illustrent le mode de fonctionnement de la présente invention,
- la figure 4a montre le principe d'utilisation du convertisseur selon l'invention en tant que source de tension,
- la figure 4b montre le principe d'utilisation du convertisseur selon l'invention en tant que source de courant.

### DESCRIPTION DETAILLEE DE L'INVENTION

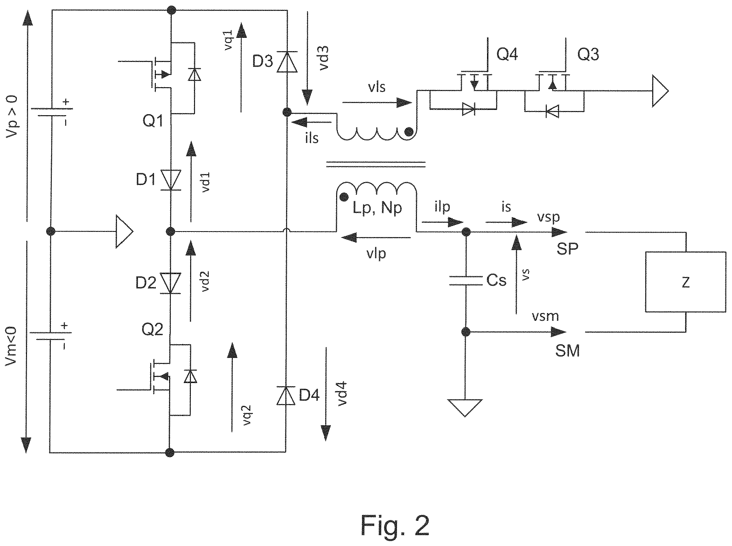

La figure 2 est un schéma électrique d'un convertisseur à découpage fournissant une tension continue aux bornes d'une charge selon un mode de réalisation particulier de la présente invention.

Le convertisseur est alimenté par une tension positive Vp (par exemple +25V) et une tension négative Vm (par exemple -25V) par rapport à la masse.

Il comprend un élément formant transformateur et comprenant deux enroulements Lp, Ls bobinés autour d'un unique noyau magnétique. Le sens de bobinage est indiqué par un point sur la figure 2. L'enroulement Ls constitue le secondaire de l'élément formant transformateur et l'enroulement Lp constitue le primaire de l'élément formant transformateur. Np étant le nombre de spires de l'enroulement Lp et Ns étant le nombre de spires de l'enroulement Ls, Np est ici sensiblement égal à Ns.

L'enroulement Lp a une première extrémité reliée à la cathode d'une diode D1 et à l'anode d'une diode D2. La deuxième extrémité de l'enroulement Lp est reliée à la première borne de sortie SP du circuit. Un condensateur de lissage Cs est branché entre la première borne de sortie SP et la masse. La deuxième borne de sortie SM peut être reliée à la masse mécanique directement, ou via une résistance, suivant le besoin de l'utilisateur.

Par ailleurs, une première borne d'un interrupteur Q1 est reliée à l'anode de la diode D1 et sa deuxième borne est reliée à la tension Vp. Une première borne d'un interrupteur Q2 est reliée à la cathode de la diode D2 et sa deuxième borne est reliée à la tension Vm.

Les interrupteurs Q1 et Q2 sont avantageusement des éléments à transistors.

De préférence, les deux interrupteurs Q1 et Q2 sont des éléments à transistors MOSFET à canal N ou à canal P, suivant les besoins de l'utilisateur. Ici l'interrupteur Q1 est de type à canal P et l'interrupteur Q2 est de type à canal N.

En outre, l'enroulement Ls a une première extrémité reliée à la cathode d'une diode D4 et à l'anode d'une diode D3. La cathode de la diode D3 est reliée à la tension Vp et l'anode de la diode D4 est reliée à la tension Vm. La diode D3 est donc montée en inverse par rapport à la tenson Vp et la diode D4 est montée à l'inverse de la diode D3.

Selon l'invention, la deuxième extrémité de l'enroulement Ls est reliée à une première borne d'un interrupteur Q4 dont la deuxième borne est reliée à la première borne d'un interrupteur Q3, les deux interrupteurs formant ensemble un interrupteur bidirectionnel. La deuxième borne de l'interrupteur Q3 est reliée à la masse. Les deux interrupteurs Q3, Q4 dont donc montés en série entre l'enroulement Ls et la masse.

Les interrupteurs Q3 et Q4 sont avantageusement des éléments à transistors.

Ceci permet en effet de réduire l'encombrement du convertisseur, les deux interrupteurs pouvant être ménagés dans un même boîtier puisqu'ils sont agencés en série directement l'un à la suite de l'autre.

De préférence, les deux interrupteurs Q3 et Q4 sont des éléments à transistors MOSFET à canal N ou à canal P, suivant les besoins de l'utilisateur. Afin de pouvoir former un interrupteur bidirectionnel, si l'interrupteur Q3 est de type à canal P, l'interrupteur Q4 est de type à canal N et inversement. Ici l'interrupteur Q3 est de type à canal N et l'interrupteur Q4 est de type à canal P.

Ainsi, il existe la même dynamique de commande au niveau des deux interrupteurs Q1 et Q2 qu'au niveau des interrupteurs Q3 et Q4. Il s'avère donc possible non seulement de coupler d'une part la commande des interrupteurs Q1 et Q3 mais également de coupler d'autre part la commande des interrupteurs Q2 et Q4.

Ceci permet de simplifier le fonctionnement du convertisseur.

La figure 2 mentionne les tensions suivantes :
- vq1 aux bornes de Q1,
- vq2 aux bornes de Q2,
- vd1 aux bornes de D1,
- vd2 aux bornes de D2,
- vd3 aux bornes de D3,
- vd4 aux bornes de D4,
- vls aux bornes de Ls,
- vlp aux bornes de Lp, et
- vs aux bornes de Cs, soit la tension de sortie du convertisseur.

La figure 2 mentionne également les courants suivants :
- ils traversant l'enroulement Ls,
- ilp traversant l'enroulement Lp, et
- is traversant la charge Z du convertisseur, soit le courant de sortie.

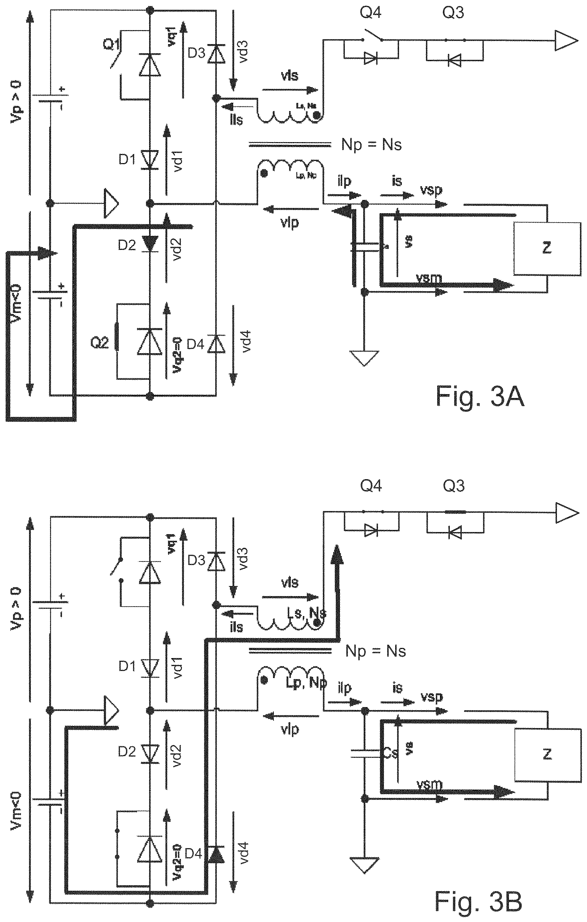

Le fonctionnement du convertisseur à découpage va maintenant être expliqué à l'aide des figures 3A à 3N en fonction des commandes (fermeture, ouverture) envoyées aux interrupteurs Q1 et Q2 et en fonction des commandes (fermeture, ouverture) envoyées aux interrupteurs Q3 et Q4 sachant que dans le présent exemple, non limitatif, la commande des interrupteurs Q1 et Q3 est couplée de même que la commande des interrupteurs Q2 et Q4. Sur ces figures, les courants qui circulent dans le circuit sont indiqués par des traits gras. Comme on le verra, le convertisseur selon l'invention est un convertisseur deux quadrants: (vs>0, is>0) et (vs<0, is<0).

Les figures 3A à 3F concernent un mode de fonctionnement où d'une part un seul transistor Q1 ou Q2 (formant interrupteur) conduit lorsque le courant de sortie est positif (is>0) ou lorsque le courant de sortie est négatif (is<0), et d'autre part un seul transistor Q3 ou Q4 (formant interrupteur) conduit lorsque le courant de sortie est positif (is>0) ou lorsque le courant de sortie est négatif (is<0).

Les figures 3A à 3C concernent un mode de fonctionnement où le courant de sortie is est négatif, pour un cycle de fonctionnement (de t=0 à t=T).

La figure 3A illustre une première étape du cycle de fonctionnement entre les instants t=0 et t=t1 (avec t1<T). Le circuit peut fonctionner en mode continu et en mode discontinu. Au cours de cette étape, la commande du circuit est telle que :
- Q2, Q3 et D4 conduisent,
- Q1, Q4 et D1, D2 et D3 sont bloqués.

La figure 3B illustre une deuxième étape du cycle de fonctionnement, entre les instants t=t1 et t=t2. Le circuit peut fonctionner en mode continu (dans ce cas t2=T) ou en mode discontinu. Au cours de cette étape, la commande du circuit est telle que :
- Q2, Q3 et Q4 et D2 conduisent,
- Q1, D1, D3 et D4 sont bloqués.

La commande des interrupteurs Q1 et Q3 demeure ainsi inchangée entre la première étape et la deuxième étape.

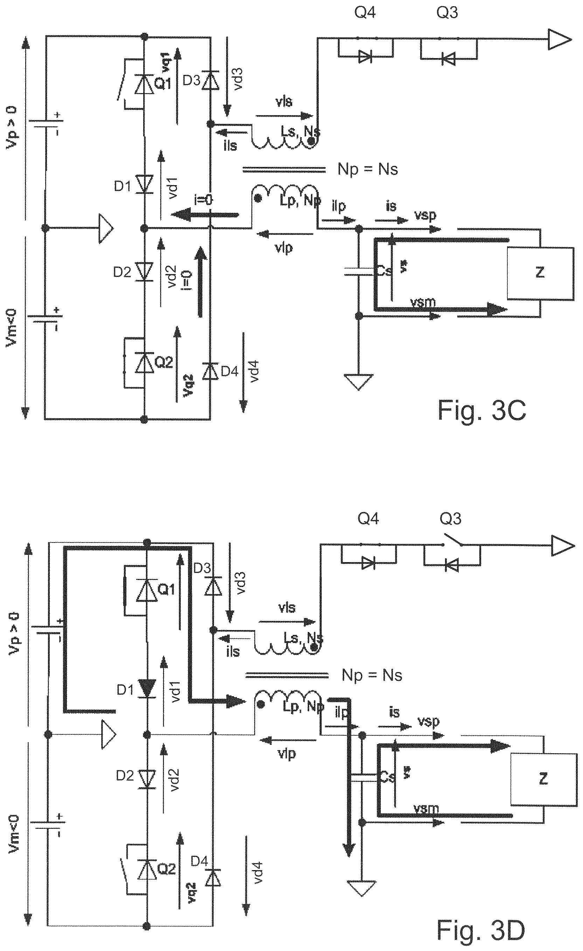

La figure 3C illustre une troisième étape du cycle de fonctionnement, uniquement pour le mode discontinu, entre t=t2 et t=T. Au cours de cette étape, la commande du circuit est telle que :
- Q2, Q3 et Q4 conduisent,
- Q1 ainsi que D1, D2, D3 et D4 sont bloqués,
- le courant is circulant dans la charge est fourni par l'énergie accumulée dans le condensateur Cs.

La commande des interrupteurs Q1, Q2, Q3 et Q4 demeure ainsi inchangée entre la deuxième étape et la troisième étape.

Les figures 3D à 3F concernent un mode de fonctionnement où le courant de sortie is est positif, pour un cycle de fonctionnement (de t=0 à t=T).

La figure 3D illustre une première étape du cycle de fonctionnement entre les instants t=0 et t=t1 (avec t1<T). Le circuit peut fonctionner en mode continu et en mode discontinu. Au cours de cette étape, la commande du circuit est telle que :
- Q1, Q4 et D3 conduisent,
- Q2, Q3, D1, D2 et D4 sont bloqués.

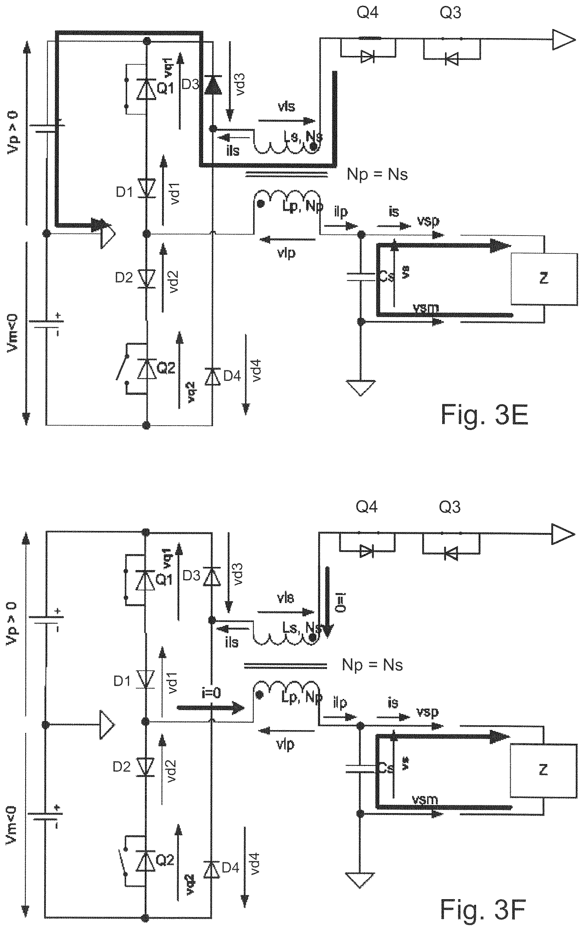

La figure 3E illustre une deuxième étape du cycle de fonctionnement, entre les instants t=t1 et t=t2. Le circuit peut fonctionner en mode continu (dans ce cas t2=T) ou en mode discontinu. Au cours de cette étape, la commande du circuit est telle que :
- Q1, Q3, Q4 et D1 conduisent,
- Q2, D2, D3 et D4 sont bloqués.

La commande des interrupteurs Q2 et Q4 demeure ainsi inchangée entre la première étape et la deuxième étape.

La figure 3F illustre une troisième étape du cycle de fonctionnement, uniquement pour le mode discontinu, entre t=t2 et t=T. Au cours de cette étape, la commande du circuit est telle que :
- Q2, D1, D2, D3 et D4 sont bloqués,
- Q1, Q3 et Q4 conduisent,
- le courant is circulant dans la charge est fourni par l'énergie accumulée dans le condensateur Cs.

La commande des interrupteurs Q1, Q2, Q3 et Q4 demeure ainsi inchangée entre la deuxième étape et la troisième étape.

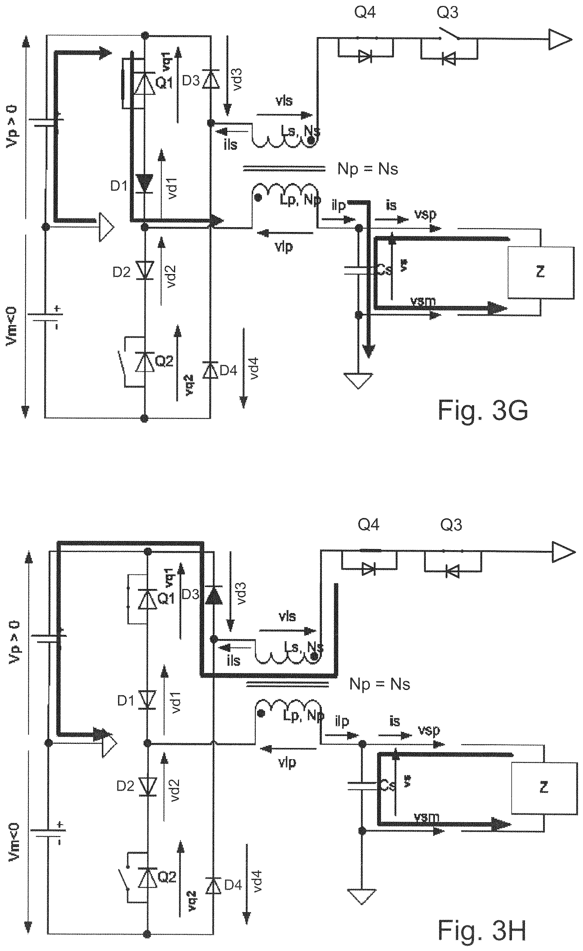

Les figures 3G à 3N concernent un mode de fonctionnement où les deux transistors Q1 et Q2 (formant interrupteur) conduisent lorsque le courant de sortie est négatif (is<0) et lorsque le courant de sortie est positif (is>0). Le fonctionnement décrit est en mode continu.

Les figures 3G à 3J concernent un mode de fonctionnement où le courant de sortie is est négatif, pour un cycle de fonctionnement (de t=0 à t=T).

La figure 3G illustre une première étape du cycle de fonctionnement, entre les instants t=0 et t=t1. Au cours de cette étape, la commande du circuit est telle que :
- Q1, Q4 et D3 conduisent,
- Q2, Q3, D1 et D4 sont bloqués,
- D2 est bloquée si la tension en sortie SP par rapport à la masse est, en valeur absolue, suffisamment faible.

La figure 3H illustre une deuxième étape du cycle de fonctionnement, entre les instants t=t1 et t=t2. Au cours de cette étape, la commande du circuit est telle que :
- Q1, Q3, Q4, D1 conduisent,
- Q2, D2, D3 et D4 sont bloqués.

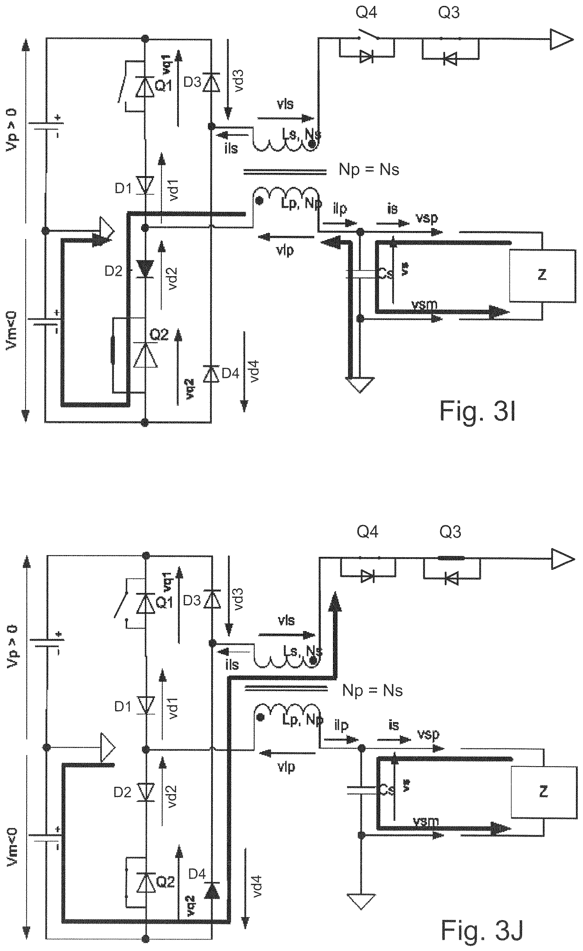

La figure 3I illustre une troisième étape du cycle de fonctionnement, entre les instants t=t2 et t=t3. Au cours de cette étape, la commande du circuit est telle que :
- Q2, Q3 et D4 conduisent,
- Q1, Q4, D1, D2 et D3 sont bloqués.

La figure 3J illustre une quatrième étape du cycle de fonctionnement, entre les instants t=t3 et t=T. Au cours de cette étape, la commande du circuit est telle que :
- Q2, Q3, Q4 et D2 conduisent,
- Q1, D1, D3 et D4 sont bloqués.

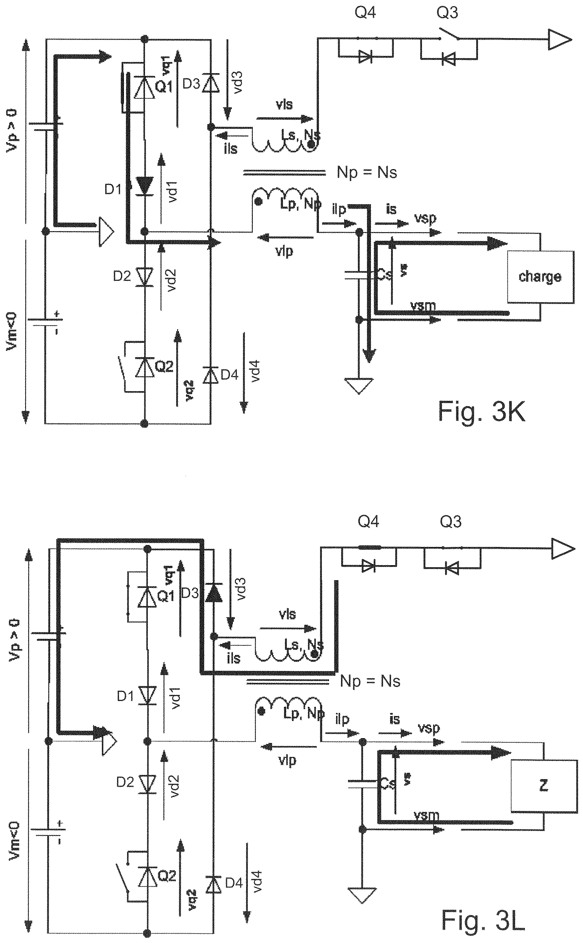

Les figures 3K à 3N concernent un mode de fonctionnement où le courant de sortie is est positif, pour un cycle de fonctionnement (de t=0 à t=T).

La figure 3K illustre une première étape du cycle de fonctionnement, entre les instants t=0 et t=t1. Au cours de cette étape, la commande du circuit est telle que :
- Q1, Q4 et D3 conduisent,
- Q2, Q3, D1, D2 et D4 sont bloqués.

La figure 3L illustre une deuxième étape du cycle de fonctionnement, entre les instants t=t1 et t=t2. Au cours de cette étape, la commande du circuit est telle que :
- Q1, Q3, Q4 et D1 conduisent,
- Q2, D2, D3 et D4 sont bloqués.

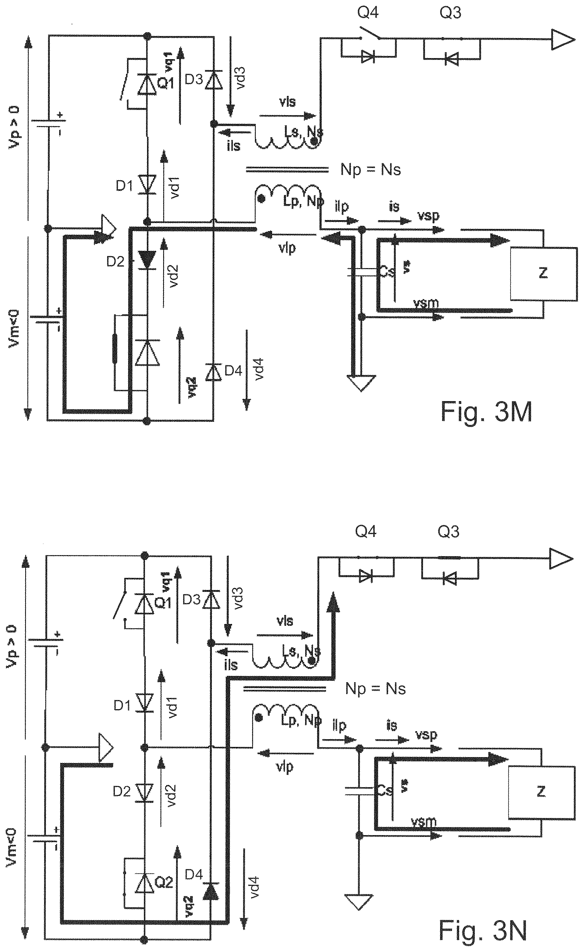

La figure 3M illustre une troisième étape du cycle de fonctionnement, entre les instants t=t2 et t=t3. Au cours de cette étape, la commande du circuit est telle que :
- Q2, Q3 et D4 conduisent,
- Q1, Q4, D2 et D3 sont bloqués,
- D1 est bloquée si la tension en sortie de SP par rapport à la masse est, en valeur absolue, suffisamment faible.

La figure 3N illustre une quatrième étape du cycle de fonctionnement, entre les instants t=t3 et t=T. Au cours de cette étape, la commande du circuit est telle que :
- Q2, Q3 et Q4 et D2 conduisent,
- Q1, D1, D3 et D4 sont bloqués.

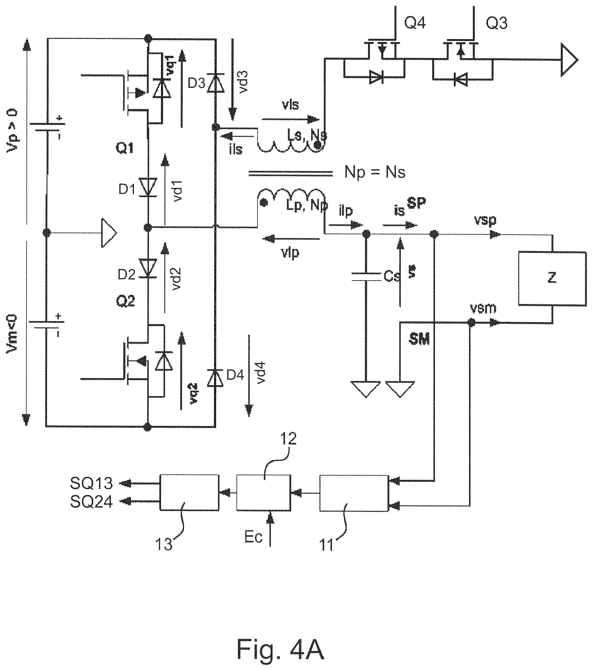

La figure 4a montre le principe d'utilisation du convertisseur selon l'invention en tant que source de tension par l'ajout d'un moyen de mesure 11 de la tension différentielle entre les sorties SP et SM, d'un correcteur 12 adéquat recevant une consigne Ec et d'un modulateur 13 adéquat. Les sorties du modulateur 13 fournissent la tension de commande SQ13 pour les transistors Q1 et Q3 ainsi que la tension de commande SQ24 pour les transistors Q2 et Q4.

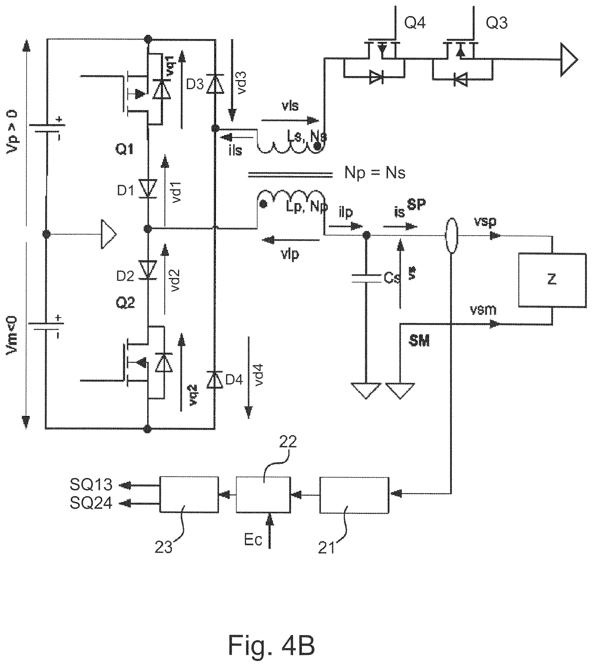

La figure 4b montre le principe d'utilisation du convertisseur selon l'invention en tant que source de courant par l'ajout d'un moyen de mesure 21 de courant de sorties is du convertisseur, d'un correcteur 22 adéquat recevant une consigne Ec et d'un modulateur 23 adéquat. Les sorties du modulateur 23 fournissent la tension de commande Q13 pour les transistors Q1 et Q3 ainsi que la tension de commande SQ24 pour les transistors Q2 et Q4.

On constate ainsi que le convertisseur selon l'invention peut être, de la même manière que pour le convertisseur décrit sur les figures la et 1b, converti en source de courant à découpage par l'ajout d'un moyen (direct ou indirect) de mesure du courant de la charge et des correcteur et modulateur adéquats. De la même manière, on constate que le convertisseur selon l'invention peut être converti en source de tension à découpage par l'ajout d'un moyen (direct ou indirect) de mesure de la tension différentielle aux bornes de la charge et des correcteur et modulateur adéquats.

L'invention n'est pas limitée à ce qui vient d'être décrit et englobe toute variante entrant dans le cadre défini par les revendications.

En particulier, bien qu'ici les interrupteurs décrits soient des éléments à transistors MOSFET à canal N ou à canal P, ils pourront être remplacés par tout autre interrupteur ayant une capacité de conduction bidirectionnelle et une capacité de blocage direct.

En outre, bien qu'ici les commandes des interrupteurs Q1, Q3 d'une part et Q2, Q4 d'autre part soient couplées, il sera possible de découpler ces commandes pour contrôler plus finement le convertisseur.

## Revendications

1. Convertisseur à découpage alimenté par une tension positive (Vp) et une tension négative (Vm) par rapport à la masse, et délivrant une tension de sortie entre une première borne de sortie (SP) et une deuxième borne de sortie (SM), cette dernière étant reliée directement à la masse ou à travers une résistance, comprenant deux enroulements (Ls, Lp) bobinés en opposition autour d'un noyau magnétique :
- la première extrémité du premier enroulement (Lp) étant reliée à un point milieu d'une première branche qui relie la tension positive à la tension négative, la partie de la première branche reliant son point milieu à la tension positive comprenant, disposés en série, un premier moyen formant interrupteur (Q1) et une première diode (D1) montée en direct par rapport à la tension positive et formant ensemble un interrupteur unidirectionnel à pouvoir de blocage direct et inverse, la partie de la première branche reliant son point milieu à la tension négative comprenant, disposés en série, un deuxième moyen formant interrupteur (Q2) et une deuxième diode (D) montée en direct par rapport à la tension négative et formant ensemble un interrupteur unidirectionnel à pouvoir de blocage direct et inverse,
- la deuxième extrémité du premier enroulement (Lp) étant reliée à la borne de sortie,
- la première extrémité du deuxième enroulement (Ls) étant reliée à un point milieu d'une deuxième branche qui relie la tension positive à la tension négative et qui comprend une troisième diode (D3) et une quatrième diode (D4) montées en inverse, le point milieu de la deuxième branche étant situé entre la troisième diode et la quatrième diode,
le convertisseur étant **caractérisé en ce qu'**il comporte un troisième moyen (Q3) formant interrupteur et un quatrième moyen (Q4) formant interrupteur formant ensemble un interrupteur bidirectionnel à pouvoir de blocage direct et inverse, le troisième moyen et le quatrième moyen étant disposés en série entre la deuxième extrémité du deuxième enroulement (Ls) et la masse.

2. Convertisseur à découpage selon la revendication 1, dans lequel un condensateur de lissage (Cs) est branché entre la première borne de sortie (SP) du convertisseur et la masse.

3. Convertisseur à découpage selon l'une des revendications 1 ou 2, dans lequel, dans la première branche reliant la tension positive (Vp) à la tension négative (Vm), ladite disposition en série consiste à disposer les premier (Q1) et deuxième (Q2) moyens formant interrupteur du côté des tensions positive ou négative respectives et à disposer les première (D1) et deuxième (D2) diodes du côté du point milieu de la première branche.

4. Convertisseur à découpage selon l'une quelconque des revendications 1 à 3, dans lequel les premier (Q1), deuxième (Q2), troisième (Q3) et quatrième (Q4) moyens formant interrupteur sont choisis parmi les transistors MOS, les transistors bipolaires et les transistors IGBT ou tout autre interrupteur ayant une capacité de conduction bidirectionnelle et une capacité de blocage direct.

5. Convertisseur à découpage selon l'une des revendications précédentes, dans lequel le troisième moyen (Q3) et le quatrième moyen (Q4) formant interrupteur sont choisis parmi les transistors MOS.

6. Convertisseur à découpage selon l'une des revendications précédentes, dans lequel le troisième moyens (Q3) et le quatrième moyen (Q4) formant interrupteur sont respectivement l'un un transistor MOS à canal N et l'autre un transistor MOS à canal P.

7. Convertisseur à découpage selon l'une des revendications précédentes, dans lequel le troisième moyen (Q3) formant interrupteur est de même type que le premier moyen (Q1) formant interrupteur.

8. Convertisseur à découpage selon l'une des revendications précédentes, dans lequel le deuxième moyen (Q2) formant interrupteur est de même type que le quatrième moyen (Q4) formant interrupteur.

9. Convertisseur à découpage selon l'une quelconque des revendications 1 à 8, comprenant en outre un moyen de mesure (11) de la tension de sortie du convertisseur, ce moyen de mesure délivrant un signal de sortie représentatif de la tension de sortie à une première entrée d'un moyen de régulation (12) dont une deuxième entrée reçoit un signal de consigne, le moyen de régulation (12) délivrant un signal fourni à l'entrée d'un modulateur (13) dont une première sortie envoie un même signal de commande (SQ13) au premier moyen formant interrupteur (Q1) et au troisième moyen formant interrupteur (Q3) et dont une deuxième sortie envoie un même signal de commande (SQ24) au deuxième moyen formant interrupteur (Q2) et au quatrième moyen formant interrupteur (Q4), le convertisseur étant ainsi configuré en source de tension.

10. Convertisseur à découpage selon l'une quelconque des revendications 1 à 8, comprenant en outre un moyen de mesure (21) du courant de sortie (is) du convertisseur, ce moyen de mesure délivrant un signal de sortie représentatif du courant de sortie du convertisseur à une première entrée d'un moyen de régulation (22) dont une deuxième entrée reçoit un signal de consigne, le moyen de régulation (22) délivrant un signal fourni à l'entrée d'un modulateur (23) dont une première sortie envoie un même signal de commande (SQ13) au premier moyen formant interrupteur (Q1) et au troisième moyen formant interrupteur (Q3) et dont une deuxième sortie envoie un même signal de commande (SQ24) au deuxième moyen formant interrupteur (Q2) et au quatrième moyen formant interrupteur (Q4), le convertisseur étant ainsi configuré en source de courant.

11. Commande d'actuateur électromécanique comportant un convertisseur à découpage selon l'une quelconque des revendications 1 à 10.

12. Automate de régulation comportant un convertisseur à découpage selon l'une quelconque des revendications 1 à 10.

13. Equipement terrestre, naval ou aéronautique comportant un convertisseur à découpage selon l'une quelconque des revendications 1 à 10.

14. Turbomoteur comportant un convertisseur à découpage selon l'une quelconque des revendications 1 à 10.

## Patentansprüche

1. Schaltwandler, der von einer positiven Spannung (Vp) und einer negativen Spannung (Vm), jeweils auf die Masse bezogen, gespeist wird und zwischen einer ersten Ausgangsklemme (SP) und einer zweiten Ausgangsklemme (SM) eine Ausgangsspannung liefert, wobei die zweite Ausgangsklemme direkt mit der Masse oder über einen Widerstand verbunden ist, wobei der Schaltwandler zwei Wicklungen (Ls, Lp) umfasst, die gegenläufig um einen Magnetkern gewickelt sind:
- wobei das erste Ende der ersten Wicklung (Lp) mit einem mittleren Punkt eines ersten Zweigs verbunden ist, der die positive Spannung mit der negativen Spannung verbindet, wobei der Teil des ersten Zweigs, der dessen mittleren Punkt mit der positiven Spannung verbindet, in Reihe angeordnet einen Schalter bildende erste Mittel (Q1) und eine erste Diode (D1) umfasst, die in Bezug auf die positive Spannung in Durchlassrichtung geschaltet ist, und die zusammen einen unidirektionalen Schalter mit Vorwärts- und Rückwärtssperrfähigkeit bilden, wobei der Teil des ersten Zweigs, der dessen mittleren Punkt mit der negativen Spannung verbindet, in Reihe angeordnet einen Schalter bildende zweite Mittel (Q2) und eine zweite Diode (D) umfasst, die in Bezug auf die negative Spannung in Durchlassrichtung geschaltet ist, und die zusammen einen unidirektionalen Schalter mit Vorwärts- und Rückwärtssperrfähigkeit bilden,
- wobei das zweite Ende der ersten Wicklung (Lp) mit der Ausgangsklemme verbunden ist,
- wobei das erste Ende der zweiten Wicklung (Ls) mit einem mittleren Punkt eines zweiten Zweigs verbunden ist, der die positive Spannung mit der negativen Spannung verbindet und der eine dritte Diode (D3) und eine vierte Diode (D4) umfasst, die in Sperrrichtung geschaltet sind, wobei sich der mittlere Punkt des zweiten Zweigs zwischen der dritten Diode und der vierten Diode befindet,
wobei der Wandler **dadurch gekennzeichnet ist, dass** er einen Schalter bildende dritte Mittel (Q3) und einen Schalter bildende vierte Mittel (Q4) umfasst, die zusammen einen bidirektionalen Schalter mit Vorwärts- und Rückwärtssperrkraft bilden, wobei die dritten Mittel und die vierten Mittel in Reihe zwischen dem zweiten Ende der zweiten Wicklung (Ls) und der Masse angeordnet sind.

2. Schaltwandler nach Anspruch 1, bei dem ein Glättungskondensator (Cs) zwischen der ersten Ausgangsklemme (SP) des Wandlers und der Masse geschaltet ist.

3. Schaltwandler nach einem der Ansprüche 1 oder 2, bei dem in dem ersten Zweig, der die positive Spannung (Vp) mit der negativen Spannung (Vm) verbindet, die genannte Reihenanordnung darin besteht, die einen Schalter bildenden ersten Mittel (Q1) und die einen Schalter bildenden zweiten Mittel (Q2) neben der positiven Spannung bzw. der negativen Spannung anzuordnen und die erste Diode (D1) und die zweite Diode (D2) neben dem mittleren Punkt des ersten Zweigs anzuordnen.

4. Schaltwandler nach einem der Ansprüche 1 bis 3, bei dem die jeweils einen Schalter bildenden ersten (Q1), zweiten (Q2), dritten (Q3) und vierten Mittel (Q4) unter den MOS-Transistoren, den bipolaren Transistoren und den IGBT-Transistoren oder jedem anderen Schalter ausgewählt werden, der eine bidirektionale Leitungskapazität und eine Vorwärts-Sperrkapazität hat.

5. Schaltwandler nach einem der vorhergehenden Ansprüche, bei dem die jeweils einen Schalter bildenden dritten Mittel (Q3) und vierten Mittel (Q4) unter den MOS-Transistoren ausgewählt werden.

6. Schaltwandler nach einem der vorhergehenden Ansprüche, bei dem die einen Schalter bildenden dritten Mittel (Q3) und vierten Mittel (Q4) jeweils zum einen ein N-Kanal-MOS-Transistor und zum anderen ein P-Kanal-MOS-Transistor sind.

7. Schaltwandler nach einem der vorhergehenden Ansprüche, bei dem die einen Schalter bildenden dritten Mittel (Q3) vom gleichen Typ sind wie die einen Schalter bildenden ersten Mittel (Q1).

8. Schaltwandler nach einem der vorhergehenden Ansprüche, bei dem die einen Schalter bildenden zweiten Mittel (Q2) vom gleichen Typ sind wie die einen Schalter bildenden vierten Mittel (Q4).

9. Schaltwandler nach einem der Ansprüche 1 bis 8, ferner umfassend Messmittel (11) zum Messen der Ausgangsspannung des Wandlers, wobei diese Messmittel ein Ausgangsignal liefern, das repräsentativ für die Ausgangsspannung an einem ersten Eingang von Regelungsmitteln (12) ist, von denen ein zweiter Eingang ein Sollwertsignal empfängt, wobei die Regelungsmittel (12) ein Signal liefern, das dem Eingang eines Modulators (13) zugeführt wird, von dem ein erster Ausgang ein gleiches Steuersignal (SQ13) an die einen Schalter bildenden ersten Mittel (Q1) und an die einen Schalter bildenden dritten Mittel (Q3) sendet und von dem ein zweiter Ausgang ein gleiches Steuersignal (SQ24) an die einen Schalter bildenden zweiten Mittel (Q2) und an die einen Schalter bildenden vierten Mittel (Q4) sendet, wobei der Wandler folglich als Spannungsquelle konfiguriert ist.

10. Schaltwandler nach einem der Ansprüche 1 bis 8, ferner umfassend Messmittel (21) zum Messen des Ausgangsstroms (is) des Wandlers wobei diese Messmittel ein Ausgangssignal liefern, das repräsentativ für den Ausgangsstrom des Wandlers an einem ersten Eingang von Regelungsmitteln (22) ist, von denen ein zweiter Eingang ein Sollwertsignal empfängt, wobei die Regelungsmittel (22) ein Signal liefern, das dem Eingang eines Modulators (23) zugeführt wird, von dem ein erster Ausgang ein gleiches Steuersignal (SQ13) an die einen Schalter bildenden ersten Mittel (Q1) und an die einen Schalter bildenden dritten Mittel (Q3) liefert, und von dem ein zweiter Ausgang ein gleiches Steuersignal (SQ24) an die einen Schalter bildenden zweiten Mittel (Q2) und an die einen Schalter bildenden vierten Mittel (Q4) sendet, wobei der Wandler folglich als Stromquelle konfiguriert ist.

11. Steuerung für einen elektromechanischen Aktor, umfassend einen Schaltwandler nach einem der Ansprüche 1 bis 10.

12. Regelungsautomat, umfassend einen Schaltwandler nach einem der Ansprüche 1 bis 10.

13. Land-, Schiffs- oder Luftfahrtausrüstung, umfassend einen Schaltwandler nach einem der Ansprüche 1 bis 10.

14. Turbomotor, umfassend einen Schaltwandler nach einem der Ansprüche 1 bis 10.

## Claims

1. A switch-mode converter powered by a positive voltage (Vp) and a negative voltage (Vm), both relative to ground, and delivering an outlet voltage between a first outlet terminal (SP) and a second outlet terminal (SM), which second outlet terminal is connected to ground either directly or via a resistance, the converter having two windings (Ls, Lp) wound in opposition about a magnetic core:
- the first end of the first winding (Lp) being connected to a midpoint of a first branch that connects the positive voltage to the negative voltage, the portion of the first branch connecting its midpoint to the positive voltage comprising a series connection of switch-forming first means (Q1) and a first diode (D1) in forward connection relative to the positive voltage and together forming a unidirectional switch having forward and reverse blocking power, the portion of the first branch connecting its midpoint to the negative voltage comprising a series connection of second switch-forming means (Q2) and a second diode (D) forwardly mounted relative to the negative voltage and together forming a unidirectional switch having forward and reverse blocking power;
- a second end of the first winding (Lp) being connected to the outlet terminal; and
- the first end of the second winding (Ls) being connected to a midpoint of a second branch that connects the positive voltage to the negative voltage and that comprises a third diode (D3) and a fourth diode (D4) in reverse connection, the midpoint of the second branch being situated between the third diode and the fourth diode;
the converter being **characterized in that** it includes third switch-forming means (Q3) and fourth switch-forming means (Q4) together forming a bidirectional switch having forward and reverse blocking power, the third and fourth means being arranged in series between the second end of the second winding (Ls) and ground.

2. A switch-mode converter according to claim 1, wherein a smoothing capacitor (Cs) is connected between the first outlet terminal (SP) of the converter and ground.

3. A switch-mode converter according to claim 1 or claim 2, wherein, in the first branch connecting the positive voltage (Vp) to the negative voltage (Vm), said series connection consists in arranging the first and second switch-forming means (Q1 and Q2) beside the respective positive and negative voltages and in arranging the first and second diodes (D1 and D2) beside the midpoint of the first branch.

4. A switch-mode converter according to any one of claims 1 to 3, wherein the first, second, third, and fourth switch-forming means (Q1, Q2, Q3, and Q4) are selected from MOS transistors, bipolar transistors, and insulated gate bipolar transistors (IGBTs), or any other switch having a capacity for conducting bidirectionally and a capacity for forward blocking.

5. A switch-mode converter according to any preceding claim, wherein the third and fourth switch-forming means (Q3 and Q4) are selected from MOS transistors.

6. A switch-mode converter according to any preceding claim, wherein the third and fourth switch-forming means (Q3 and Q4) are respectively one of them an N channel MOS transistor and the other one a P channel MOS transistor.

7. A switch-mode converter according to any preceding claim, wherein the third switching means (Q3) is of the same type as the first switch-forming means (Q1).

8. A switch-mode converter according to any preceding claim, wherein the second switch-forming means (Q2) is of the same type as the fourth switch-forming means (Q4).

9. A switch-mode converter according to any one of claims 1 to 8, further comprising measurement means (11) for measuring the outlet voltage of the converter, the measurement means delivering an output signal representative of the outlet voltage to a first input of regulator means (12) having a second input receiving a setpoint signal, the regulator means (12) delivering a signal that is supplied to the input of a modulator (13) having a first output sending a common control signal (SQ13) to the first switch-forming means (Q1) and to the third switch-forming means (Q3), and having a second output sending a common control signal (SQ24) to the second switch-forming means (Q2) and to the fourth switch-forming means (Q4), the converter thus being configured as a voltage source.

10. A switch-mode converter according to any one of claims 1 to 8, further comprising measurement means (21) for measuring the outlet current (is) of the converter, the measurement means delivering an output signal representative of the outlet current of the converter to a first input of regulator means (22) having a second input receiving a setpoint signal, the regulator means (22) delivering a signal that is supplied to the input of a modulator (23) having a first output that sends a common control signal (SQ13) to the first switch-forming means (Q1) and to the third switch-forming means (Q3), and a second output that sends a common control signal (SQ24) to the second switch-forming means (Q2) and to the fourth switch-forming means (Q4), the converter thus being configured as a current source.

11. An electromechanical actuator control including a switch-mode converter according to any one of claims 1 to 10.

12. A regulator including a switch-mode converter according to any one of claims 1 to 10.

13. Terrestrial, marine, or aviation equipment including a switch-mode converter according to any one of claims 1 to 10.

14. A turbine engine including a switch-mode converter according to any one of claims 1 to 10.
